# EUROPÄISCHE PATENTSCHRIFT

(11) **EP 0 272 521 B1**
(45) Veröffentlichungstag und Bekanntmachung des Hinweises auf die Patenterteilung: **17.03.1993**
(21) Anmeldenummer: 87118019.6
(22) Anmeldetag: 05.12.1987
(51) Int. Cl.: H05K 7/14, H05K 7/20

(54) **Einschiebbare Baugruppe mit Kühlrippen**
Slide-in unit with cooling ribs
Unité enfichable avec ailettes de refroidissement

(30) Priorität: 19.12.1986 DE 3643433
(43) Veröffentlichungstag der Anmeldung: 29.06.1988
(73) Patentinhaber: Alcatel SEL Aktiengesellschaft, D-70435 Stuttgart (DE)
(72) Erfinder: Horn, Harro, D-7015 Korntal-Münchingen 1 (DE); Pickel, Wolfgang, D-7000 Stuttgart 1 (DE)
(74) Vertreter: Gähr, Hans-Dieter, Dipl.-Ing. (FH)

(56) Entgegenhaltungen:
- DE-A- 2 613 354
- DE-A- 3 503 813
- US-A- 3 535 594

## Beschreibung

Die Erfindung betrifft eine Baugruppe zum Einschieben in einen Baugruppenträger der Nachrichtentechnik nach dem Oberbegriff des Anspruchs 1.

Es ist allgemein üblich, einschiebbare Baugruppen mit einer Frontplatte zu versehen, die mit vertikalen Kühlrippen ausgerüstet ist, um eine gute Ableitung der im Innern der Baugruppe von elektrischen Bauelementen erzeugten Wärme an die vorbeiströmende Luft zu erreichen (z.B. DE-OS 35 03 813).

Ferner ist es bekannt, an einschiebbaren Baugruppen Vorrichtungen zum Herausziehen aus dem Baugruppenträger vorzusehen. Meist sind diese Vorrichtungen als Hebel ausgeführt, um die Einschübe durch Hebelwirkung leichter aus der Steckverbindung lösen zu können (z.B. DE-OS 35 01 537, 34 07 877).

Der Erfindung liegt die Aufgabe zugrunde, für die eingangs genannte Baugruppe eine besonders einfache Vorrichtung zum Ziehen zu schaffen. Gelöst wird diese Aufgabe durch die im Kennzeichen des Anspruchs 1 angegebenen Merkmale. Weiterbildugnen sind den Unteransprüchen zu entnehmen.

Der Vorteil dieser Anordnung liegt einmal in seiner kostengünstigen Herstellung und zum andern in seiner einfachen Montage, die auch Nachrüsten ermöglicht. An der Baugruppe selbst bedarf es lediglich einer Bohrung in den Kühlrippen ihrer Frontplatte, in die der Ziehgriff einknöpfbar ist. Im unbenutzten bzw. eingeschwenkten Zustand zeichnet er sich durch seine Unauffälligkeit aus. Schließlich eignet er sich nicht nur zum Ziehen der Baugruppe, sondern auch als unverlierbare Traghilfe.

Die Erfindung wird an einem Ausführungsbeispiel näher beschrieben, das in den zugehörigen Zeichnungen dargestellt ist. Darin zeigen:
- Fig 1 und 2: einen Baugruppe mit Kühlrippen und Ziehgriff in Teilseitenansicht und Draufsicht;
- Fig 3 und 4: den Ziehgriff der Baugruppe nach Fig. 1, als Einzelteil, vergrößert, in Seiten- und Vorderansicht.

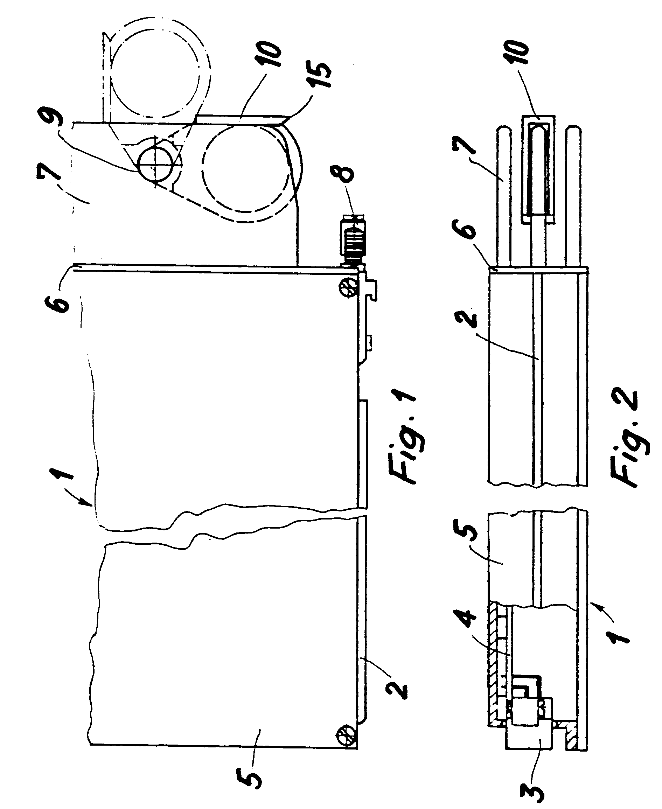

Die Baugruppe 1 in den Fig. 1 und 2 ist zum Einschieben in Baugruppenträger, z.B. eines Gestells der Nachrichtentechnik, geeignet. Sie ist deshalb an der Ober- und an der Unterseite mit je einer Führungsschiene 2 versehen. An der Rückseite sind Steckverbinder 3 mit den elektrischen Anschlüssen der Schaltungsplatte 4 im Innern des Gehäuses 5 der Baugruppe 1 angebracht. Die Frontplatte 6 ist mit Kühlrippen 7 zur Ableitung der von der elektrischen Bauelementen auf der Schaltungsplatte 4 erzeugten Wärme ausgerüstet. Am unteren Ende der Frontplatte 6 ist ein Riegel 8 erkennbar, mittels dessen die Baugruppe 1 im Baugruppenträger verriegelt werden kann (nicht dargestellt).

Mindestens eine der Kühlrippen 7 ist mit einer Bohrung 9 versehen, in die ein Ziehgriff 10 eingehängt ist. Der Ziehgriff 10 wird nach Möglichkeit an einer Stelle angebracht, die dem Schwerpunkt der Baugruppe 1 am nächsten kommt, weil sich die Baugruppe dann am besten handhaben läßt. Da die Bohrung 9 für den Ziehgriff im Regelfall in einer Kühlrippe liegt, die zwischen weiteren steht, werden entweder alle oder die Kühlrippen von einer Seite bis zur gewünschten Stelle durchbohrt.

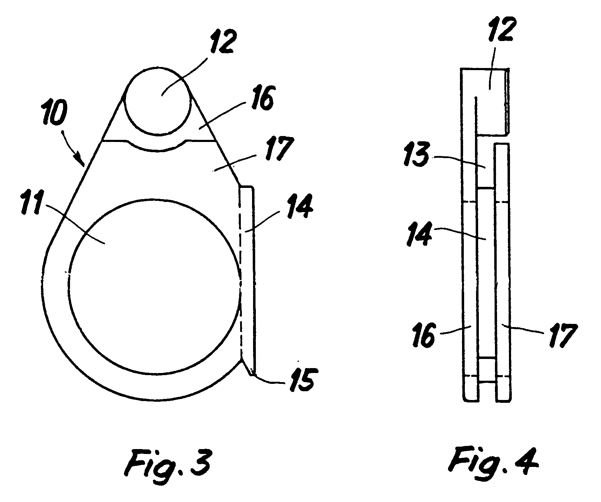

Der Ziehgriff 10 ist in Fig. 3 und 4 vergößert dargestellt. Er ist aus Kunststoff geformt und hat ungefähr eiförmigen Grundriß. Im Bereich des großen Halbmessers ist ein Fingerloch 11, im Bereich des kleinen Halbmessers ein Zapfen 12 angeordnet, der in die Bohrung 9 der Kühlrippe 7 an der Baugruppe 1 paßt. Ferner hat der Ziehgriff 10 durchgehend gleichmäßige Dicke, ist jedoch in der Mitte zwischen den flachen Außenseiten durch einen Schlitz 13 weitgehend in zwei Teile 16 und 17 gleicher Dicke geteilt, die nur durch einen Steg 14 verbunden sind, der das Fingerloch 11 tangiert. Der Steg 14 liegt im Grundriß etwa rechtwinklig zum Zapfen 12. Dieser Zapfen ist dem einen Teil 16 angeformt und ragt frei bis in die Ebene der Außenfläche des anderen Teils 17, der im Bereich des Zapfens so weit verkürzt ist, daß er den Zapfen nicht berührt. Der Steg 14 ist am dem Zapfen abgewandten Ende zu einer Grifflippe 15 velängert.

Die Breite des Schlitzes 13 im Ziehgriff 10 entspricht etwa der Dicke einer Kühlrippe 7 der Baugruppe 1, die Dicke der beiden Teile 16 und 17 des Ziehgriffes ist geringer als der Abstand zweier Kühlrippen.

Beim Einsetzen des Ziehgriffes 10 in die Baugruppe 1 wird der Zapfen 12 seitlich weggedrückt, so daß sich der Ziehgriff mit dem Schlitz auf eine Kühlrippe 7 schieben läßt. Sobald der Zapfen 12 die Bohrung 9 in der Kühlrippe erreicht, schnappt er ein und ist kraftschlüssig drehbeweglich gehaltert. Bei Nichtgebrauch wird der Ziehgriff 10 zwischen die Kühlrippen 7 eingeschwenkt, bis er mit seinem Steg 14 an der Rippenkante anliegt, wie Fig. 1 und 2 zeigen. Soll die Baugruppe 1 aus dem Baugruppenträger gezogen werden, so wird der Ziehgriff in die strichpunktiert in Fig. 1 dargestellte Stellung geschwenkt, was mit Hilfe der Grifflippe 15 leicht zu bewerkstelligen ist. An diesem Ziehgriff 10 kann die Baugruppe 1 nicht nur herausgezogen, sondern auch gut getragen werden.

## Patentansprüche

1. Baugruppe zum Einschieben in einen Baugruppenträger der Nachrichtentechnik mit einer Frontplatte, die mit Kühlrippen versehen ist,
**dadurch gekennzeichnet,** daß mindestens in einer Kühlrippe (7) eine Bohrung (9) angebracht ist, in die ein elastischer Ziehgriff (10) mit einem Fingerloch (11) mittels eines angeformten Zapfens (12) drehbeweglich eingehängt und zwischen die Kühlrippen einschwenkbar ist.

2. Baugruppe nach Anspruch 1, dadurch gekennzeichnet, daß der Ziehgriff (10) ungefähr eiförmigen Grundriß hat, wobei im Bereich des großen Halbmessers das Fingerloch (11) und im Bereich des kleinen Halbmessers der Zapfen (12) angeordnet ist.

3. Baugruppe nach Anspruch 2, dadurch gekennzeichnet, daß der Ziehgriff (10) durchgehend gleiche Dicke aufweist und in der Mitte zwischen den ebenen Außenflächen durch einen Schlitz (13), der der Dicke einer Kühlrippe (7) entspricht, in zwei Teile (16, 17) geteilt ist, die nur durch einen Steg (14) verbunden sind, der das Fingerloch (11) tangiert.

4. Baugruppe nach Anspruch 3, dadurch gekennzeichnet, daß der Steg (14) etwa rechtwinklig zum Zapfen (12) versetzt angeordnet ist.

5. Baugruppe nach Anspruch 4, dadurch gekennzeichnet, daß der Zapfen (12) an dem einen Teil (16) angeformt und aus dem anderen Teil (17) freigeschnitten ist.

6. Baugruppe nach Anspruch 4, dadurch gekennzeichnet, daß der Steg (14) an dem vom Zapfen (12) weg weisenden Ende zu einer Grifflippe (15) verlängert ist.

## Claims

1. A plug-in unit for insertion into a communications subrack, said plug-in unit having a front panel provided with cooling fins,
**characterized in** that at least one cooling fin (7) has a hole (9) in which an elastic pull handle (10) with a finger hole (11) is rotatably mounted by means of a molded-on stud (12) and can be swung to a position between the cooling fins.

2. A plug-in unit as claimed in claim 1, characterized in that the pull handle (10) is approximately oval in plan view, the finger hole (11) being located in the area of the large radius, and the stud (12) in the area of the small radius.

3. A plug-in unit as claimed in claim 2, characterized in that the pull handle (10) has the same thickness throughout and is divided into two parts (16, 17) in the middle between the flat outside surfaces by a slot (13) corresponding to the thickness of a cooling fin (7), said two parts (16, 17) being interconnected only by a bridge portion (14) which is tangent to the finger hole (11).

4. A plug-in unit as claimed in claim 3, characterized in that the bridge portion (14) is offset at approximately right angles to the stud (12).

5. A plug-in unit as claimed in claim 4, characterized in that the stud (12) is formed integrally with one (16) of said parts and is cut free from the other part (17).

6. A plug-in unit as claimed in claim 4, characterized in that at its end remote from the stud (12), the bridge portion (14) is extended to form a grip lip (15).

## Revendications

1. Sous-ensemble enfichable dans un support de sous-ensembles selon la technique des télécommunications, comprenant une plaque frontale, munie d'ailettes de refroidissement, caractérisé en ce qu'il est prévu dans au moins une ailette de refroidissement (7) un alésage (9), dans lequel est suspendue mobile en rotation à l'aide d'un tourillon moulé, une languette de traction élastique (10) munie d'un trou de passage de doigt (11) et en ce que ladite languette est susceptible de pivoter entre les ailettes de refroidissement.

2. Sous-ensemble selon la revendication 1, caractérisé en ce que la languette de traction (10) présente un contour sensiblement en forme d'oeuf, le trou pour le passage d'un doigt (11) étant prévu dans la zone de grand diamètre, et le tourillon (12) étant disposé dans la zone de petit diamètre.

3. Sous-ensemble selon la revendication 2, caractérisé en ce que la languette de traction (10) présente la même épaisseur courante, et est séparée au milieu entre les surfaces extérieures planes, par une fente (13) qui correspond à l'épaisseur d'une ailette de refroidissement (7), en deux parties (16, 17) qui ne sont reliées que par une barrette (14) qui vient tangenter le trou (11) pour le passage d'un doigt.

4. Sous-ensemble selon la revendication 3, caractérisé en ce que la barrette (14) est disposée décalée, sensiblement perpendiculaire au tourillon (12).

5. Sous-ensemble selon la revendication 4, caractérisé en ce que le tourillon (12) est intégré de moulage pour une partie (16) et est en saillie sans dépouille pour l'autre partie (17).

6. Sous-ensemble selon la revendication 4, caractérisé en ce que la barrette (14) est prolongée, à l'extrémité s'éloignant du tourillon (12), par un lèvre de saisie (15).
